# EUROPÄISCHE PATENTSCHRIFT

(11) **EP 2 637 114 B1**
(45) Veröffentlichungstag und Bekanntmachung des Hinweises auf die Patenterteilung: **12.12.2018**
(21) Anmeldenummer: 12158442.9
(22) Anmeldetag: 07.03.2012
(51) Int. Cl.: G06F 17/50, H04L 29/06, G06F 17/30, G06F 9/54

(54) **Verfahren zur Kopplung eines CAD-Systems mit einem Datenbank- und Planungssystem zum Austausch von Daten zwischen beiden Systemen**
Method for coupling a CAD system with a database and planning system for exchanging data between both systems
Procédé de couplage d'un système CAD avec un système de base de données et de planification destiné à l'échange de données entre ces deux systèmes

(43) Veröffentlichungstag der Anmeldung: 11.09.2013
(73) Patentinhaber: CIDEON Software & Services GmbH & Co. KG, 82166 Gräfelfing (DE)
(72) Erfinder: Schaarschmidt, Stefan, 02625 Bautzen (DE); Lehmann, Andreas, 02694 Malschwitz (DE); Lisse, Rolf, 51381 Leverkusen (DE)
(74) Vertreter: Angerhausen, Christoph

(56) Entgegenhaltungen:
- KRUTH J-P ET AL: "Extracting process planning information from various wire frame and feature based CAD systems", COMPUTERS IN INDUSTRY, ELSEVIER SCIENCE PUBLISHERS. AMSTERDAM, NL, Bd. 30, Nr. 2, 30. September 1996 (1996-09-30), Seiten 145-162, XP004013452, ISSN: 0166-3615, DOI: 10.1016/0166-3615(96)00039-5
- NAKAMURA I ET AL: "A CAD DATABASE INTERFACE BASED ON STEP", IFIP TRANSACTIONS B. APPLICATIONS IN TECHNOLOGY, ELSEVIER SCIENCE PUBLISHING, AMSTERDAM, NL, Bd. B-10, 15. März 1993 (1993-03-15), Seiten 115-129, XP008046326, ISSN: 0926-5481
- KONSTANTINOV G ED - INSTITUTE OF ELECTRICAL AND ELECTRONICS ENGINEERS: "Emerging standards for design management systems", COMPUTER STANDARDS EVOLUTION : IMPACT AND IMPERATIVES. WASHINGTON, MARCH 21 - 23, 1988; [PROCEEDINGS OF THE COMPUTER STANDARDS CONFERENCE. (COMPSTAN)], WASHINGTON, IEEE COMP. SOC. PRESS, US, Bd. CONF. 2, 21. März 1988 (1988-03-21), Seiten 16-21, XP010011340, DOI: 10.1109/CSTAND.1988.4754 ISBN: 978-0-8186-0791-2

## Beschreibung

Die Erfindung betrifft ein Verfahren zur Kopplung eines CAD-Systems mit einem Datenbank- und Planungssystem zum Austausch von Daten zwischen beiden Systemen, wobei eine erste CAD-seitige Schnittstelle mit einem ersten Kommunikationsprotokoll arbeitend und eine zweite datenbankseitige Schnittstelle mit einem zweiten Kommunikationsprotokoll arbeitend bereitgestellt werden und wobei zwischen der ersten und der zweiten Schnittstelle eine Umsetzung der zu übertragenden Daten aus dem ersten Kommunikationsprotokoll in das zweite Kommunikationsprotokoll und umgekehrt erfolgt, wobei ein Schnittstellen-Modul bereitgestellt wird, welches einen Nutzlayer und einen CAD-Abstraktionslayer beinhaltet und in welchem die Umsetzung zwischen den Kommunikationsprotokollen in zwei Teilschritten derart erfolgt, dass die Daten aus dem ersten Kommunikationsprotokoll in dem CAD-Abstraktionslayer in ein drittes Kommunikationsprotokoll und nachfolgend aus diesem dritten Kommunikationsprotokoll in das zweite Kommunikationsprotokoll in dem Nutzlayer umgesetzt werden und umgekehrt.

Verfahren zur Kopplung von CAD-Anwendungen an Datenbank- und/oder Planungssysteme wie SAP (SAP GmbH Systeme, Anwendungen und Produkte in der Datenverarbeitung) nach dem Stand der Technik werden beispielsweise mittels einer CAD-seitigen ersten Schnittstelle, einer datenbankseitigen zweiten Schnittstelle und einem zwischen beiden Schnittstellen angeordneten Software- oder Schnittstellen-Modul realisiert. Dabei ist das Modul speziell auf die Kopplung zweier spezieller Systeme ausgerichtet. Als Schnittstellen werden beispielsweise meist vom Hersteller bereitgestellte, sogenannte Programmierschnittstellen (API - application programming interface) genutzt.

Ändert sich auf der einen Seite das CAD-System oder auf der anderen Seite das Datenbank- und/oder Planungssystem, so muss das zwischengeschaltete Modul neu programmiert werden, um die gewünschte Funktionalität nach einer Änderung wieder bereitzustellen. Diese Neuprogrammierung kann Teile oder das gesamte Modul betreffen.

Derartige CAD-Integrationen bestehen schon mindestens seit den 1990er Jahren. Auch die Fa. CIDEON Software hat bereits langjährige Erfahrung mit CAD-Schnittstellen-Modulen zum SAP und anderen Systemen. Die Anwendung "AutoORG STL" gab es zum einen als Schnittstellen-Modul von AutoCAD zu einer eigenen DBase- oder Oraclebasierten Datenbank, zum anderen als Schnittstellen-Modul zu SAP. "AutoORG STL" wurde im Jahr 1996 von der SAP zertifiziert. Später wurden von CIDEON Software weitere Schnittstellen-Module zu Systemen wie BAAN-PDM, AMS und ProAlpha entwickelt.

Die Module waren als AutoCAD-arx-Module implementiert. Die Integrationen stellten also eine feste Verbindung zwischen einem CAD System und einem Datenbank- und/oder Planungssystem, auch Backend-System genannt, her. Für eine neue CAD Version, mitunter schon für ein neues Service Packs des CAD Systems waren die Schnittstellen-Module mindestens neu zu kompilieren oder gegebenenfalls programmtechnisch anzupassen. Ein neues CAD System anzubinden machte immer eine Neuentwicklung der Integration notwendig.

Derartige Schnittstellen-Module weisen Nachteile wie einen hohen Programmiersowie Testaufwand für jede Änderung oder jede neue Kopplungsvariante auf.

In J.-P. KRUTH ET AL. "Extracting Process Planning Information from Various Wire Frame and Feature Based CAD Systems" ist ein Verfahren gemäß dem Oberbegriff der Anmeldung offenbart, bei welchem das neutrale Definieren und Extrahieren von grafischen Features / der grafischen Beschreibung von Bauteilen (Abmessungen, Toleranzen, Aussparungen, Bohrungen) mit dem Ziel der möglichst exakten Reproduktion derselben in einem anderen System, wie beispielsweise einem CAD-System, NC oder anderen sowie das Erzeugen einer Bauteilbeschreibungsbibliothek beschrieben ist.

In I. NAKAMURA ET AL. "A CAD Database Interface Based On STEP" wird ein CAD-System offenbart und der Zugriff auf grafische Features / die grafische Beschreibung von Bauteilen (Kanten, Kurven, Flachen, Koordinaten) beschrieben, indem eine Umsetzung einer STEP-basierte Zugriffs-API auf eine CAD-API erfolgt.

Ein weiterer Stand der Technik ist aus G. KONSTANTTNOV "Emerging Standards for Design Management Systems" bekannt. Dieser beschreibt lediglich Anforderungen sowie Aufgabenstellungen und generische Empfehlungen an ein Design-Management.

Die beschriebenen Nachteile des Standes der Technik, insbesondere der hohe Programmier- sowie Testaufwand für jede Änderung oder jede neue Kopplungsvariante, können mittels dieser Offenbarungen nicht beseitigt werden.

Der Erfindung liegt somit die Aufgabe zugrunde, ein Verfahren zur Kopplung von CAD-Systemen an verschiedene Datenbank- und Planungssysteme anzugeben, welches den Aufwand bei Änderungen und Anpassungen an verschiedene Systeme verringert.

Gemäß der Erfindung wird die Aufgabe bei einem Verfahren nach Anspruch 1 zur Kopplung von CAD-Systemen der eingangs genannten Art dadurch gelöst, dass ein vom CAD-System (1) erzeugtes und an den CAD-Abstraktionslayer (5) gesendetes CAD-Event in dem CAD-Abstraktionslayer (5) in ein neutrales CAD-Event umgewandelt wird, welches mittels angeschlossener Module im Nutzlayer (4) verarbeitet werden kann Unter einem Kommunikationsprotokoll wird in der vorliegenden Beschreibung beispielsweise eine COM-, NET-, ObjectARX-, MDL-, WebService- oder Lisp-API verstanden.

Erfindungsgemäß wird die Umsetzung der Daten in zwei oder auch mehr Teilschritte oder Bereiche unterteilt. Somit ist es möglich, dass beispielsweise bei einem Austausch des verfahrensmäßig gekoppelten Datenbank- und/oder Planungssystems nur der Teilschritt an das Kommunikationsprotokoll des neuen Datenbank- und/oder Planungssystems angepasst werden muss, welcher die Umsetzung der Daten zwischen dem zweiten Kommunikationsprotokoll der zweiten datenbankseitigen Schnittstelle und dem dritten Kommunikationsprotokoll realisiert. Somit ist also der im Nutzlayer umzusetzende Teilschritt anzupassen. Somit kann der Teilschritt der Umsetzung der Daten vom dritten Kommunikationsprotokoll zum ersten Kommunikationsprotokoll, welcher im CAD-Abstraktionslayer abläuft, unverändert beibehalten werden. Für den Fall, dass beispielsweise dieser Teilschritt in weitere Unterteilschritte untergliedert ist können all diese Unterteilschritte unverändert beibehalten werden.

Vorteilhafte Weiterbildungen der Erfindung können den abhängigen Ansprüchen 2 bis 5 entnommen werden.

Es kann vorgesehen sein, dass im CAD-Abstraktionslayer abstrahierte Kommandos hinterlegt werden, dass bei einem Aufruf eines Kommandos im CAD-System eine Übertragung dieses Kommandos an den CAD-Abstraktionslayer erfolgt, welcher das Kommando in ein abstrahiertesn Kommandos umwandelt und an angeschlossene Module im Nutzlayer übertragt.

Weiterhin kann vorgesehen sein, dass der Nutzlayer die abstrahierten Kommandos dem CAD-Abstraktionslayer mitteilt, welcher diese mittels eines Eintrags in ein CAD-Menü oder Einfügen in eine Toolbar oder mittels eines aus Scripten aufrufbaren Kommandos im CAD abrufbar bereitstellt.

In einer Ausgestaltung der Erfindung ist vorgesehen, dass bei der Umsetzung der Daten aus dem dritten Kommunikationsprotokoll in das zweite Kommunikationsprotokoll oder umgekehrt weitere Zwischenschritte zur Anpassung der Kommunikation durch

Kommunikations-Bibliotheken eingefügt werden. Erfindungsgemäß kann ein Teilschritt der Umsetzung auch in weitere Teilschritte untergliedert werden. Ein weiterer

Teilschritt einer Umsetzung kann beispielsweise in einem optional zwischen dem Datenbank- und/oder Planungssystem und dem Nutzlayer angeordneten Modul bereitgestellt werden.

In einer weiteren Ausgestaltung der Erfindung ist vorgesehen, dass die Umsetzungen zwischen den Kommunikationsprotokollen unter Beachtung weiterer CAD- oder kundenspezifischer Vorgaben erfolgen.

So kann es neben den allgemeinen Vorgaben zur Umsetzung der Daten zwischen den Kommunikationsprotokollen im Nutzlayer und/oder im CAD-Abstraktionslayer weitere zusätzliche Vorgaben geben, welche eine Anpassung an Kunden- oder CAD-spezifische Vorgaben oder zusätzliche Optionen ermöglichen.

Die Grundidee besteht darin, ein erfindungsgemäßes Schnittstellen-Modul in Form einer sogenannten "virtuellen" CAD-API zu schaffen. Diese wird von einem darunterliegenden CAD-System, wie beispielsweise SolidWorks, MicroStation, Autodesk Inventor, Solid Edge, AutoCAD oder CATIA abstrahiert.

Der darauf aufbauende Nutzlayer stellt seine Funktionalität dann auf Basis der virtuellen CAD-API zur Verfügung. Er stellt also eine Verbindung zwischen dem virtuellen CAD und dem Backend-System her.

Eine Integration zu einem weiteren "übergeordneten" Backend-System besteht erfindungsgemäß im Wesentlichen darin, einen weiteren Nutzlayer zu schaffen oder anzupassen.

Eine Integration zu einem weiteren "darunterliegenden" CAD-System besteht im Wesentlichen darin, einen weiteren CAD-Abstraktionslayer zu schaffen oder anzupassen.

Gemäß der vorliegenden Erfindung ergeben sich somit die nachfolgend aufgeführten Effekte und Vorteile:
- Unabhängigkeit von CAD-spezifischen Eigenheiten
- Unabhängigkeit von im CAD verwendeten Technologien (COM, Web-Services, Lisp, .NET, ...)
- Unabhängigkeit von Unterschieden in der API bei verschiedenen CAD-Systemen (Objektnamen, Funktionsnamen, mögliche Parameter)
- Unabhängigkeit von Unterschieden in der API bei verschiedenen Versionen des gleichen CAD-Systems
- Unabhängigkeit von verschiedenen Ausprägungen oder Aufsätzen des gleichen CAD-Systems (AutoCAD Architectural, AutoCAD Electrical, P&ID)
- Hinzufügen virtueller Features, welches das real darunterliegende CAD System nicht besitzt (Stücklistenfunktionen im Standard-AutoCAD und in MicroStation, Schriftkopffunktionalitäten im Standard-AutoCAD und in MicroStation)
- Schnellere Integration eines weiteren CAD Systems zu einer bereits bestehenden Integration mit der vollen Funktionalität der bereits bestehenden Integration. Beim Schaffen der CAD-Abstraktionsschicht für ein neues CAD System wird automatisch eine Integration zu allen Backend-Systemen geschaffen, für die bereits eine Integration besteht
- Bei der Integration zu einem neuen Backend-System wird die Integration automatisch für sämtliche CAD-Systeme hergestellt, für die bereits eine CAD-Abstraktionsschicht existiert
- Identische Konfiguration und identisches Verhalten der Integration für alle CAD, da der Layer der Geschäftslogik identisch ist. Features, die für eine Integration hinzugefügt werden, stehen sofort für alle angeschlossenen CAD zur Verfügung
- Verringerung des Dokumentationsaufwandes
- Verringerung des Supportaufwandes
- Verringerung des Testaufwandes, bzw. eine intensivere Durchtestung derjenigen Komponenten, die identisch sind je CAD-Integration
- Auch Personen ohne das spezifische Wissen von Interna des CAD-Systems oder der API des CAD-Systems können Geschäftslogik im Nutz-Layer implementieren
- Funktionalität kann auf Rechnern entwickelt und vorgetestet werden, auf welchen das Ziel-CAD-System nicht installiert ist. Auch die API des Ziel-CAD-Systems muss nicht vorhanden sein.

Nachfolgend werden einige Beispiele für abstrahierte Objekte aufgeführt:
- Dokument, Dokumentenliste: Abstraktion von der CAD Datei, oder einer Liste der geladenen Dateien
- Komponente: Benutzung des Dokuments in anderen Dokumenten ("Vorkommen", referenzierende Stelle)
- Feldsatz: Satz von benannten Attributen, wie Dateiattribute, nutzerdefinierte Felder
- Projekt: Dokumentenübergreifende Zusammenfassung von Dokumenten zu einer Einheit. Beispiele: Plant3D-Project, AutoCAD Electrical Project, SheetSet
- Kommando, Kommandos: Befehle, die von der Integration bereitgestellt werden und im CAD gerufen werden können, sowie in Menüs, Buttons, Ribbons, Kontextmenüs, CAD-Kommandozeilen, Scripten und ähnlichen Befehlsaufrufern verwendet werden können
- Schriftkopf: Ein sichtbarer Bereich in Zeichnungen mit benannten Textfeldern, meist mit Dokumenteninformationen
- Ereignisse: Ereignisse im CAD wie das Öffnen oder Speichern einer Datei, das Einfügen eines Schriftkopfes, das Löschen einer Komponente werden vom CAD entgegengenommen und als Ereignis des virtuellen CADs an die angeschlossenen Module weitergeleitet
- Stücklisten, Teilelisten: Abstraktion von den CADeigenen Stücklisten
- Objekt: Abstraktion von Elementen und Inhalten des CAD-Dokumentes, wie AutoCAD-Blöcken oder MicroStation-Zellen

Die Erfindung soll nachfolgend anhand einiger Ausführungsbeispiele näher erläutert werden. In den zugehörigen Zeichnungen zeigt
- Fig. 1: eine Darstellung eines zwischen einem CAD-System und einem Datenbank- und Planungssystem angeordneten Software- oder Schnittstellenmodul nach dem Stand der Technik,
- Fig. 2: eine Darstellung der prinzipiellen Architektur eines erfindungsgemäßen Schnittstellen-Moduls,
- Fig. 3: eine Variation des Schnittstellen-Moduls für extrem CAD-nahe Funktionalitäten oder bei einer fehlenden Abdeckung einer speziellen CAD-Funktionalität in der CAD-Abstraktionsschicht,
- Fig. 4: eine weitere Variation zur Unterstützung von Ausprägungen und Aufsätzen eines CAD-Systems,
- Fig. 5: eine Darstellung des Schnittstellen-Moduls für ein Ausführungsbeispiel der Zusammenarbeit verschiedener Schichten der Architektur,
- Fig. 6: eine Darstellung des Schnittstellen-Moduls für ein weiteres Ausführungsbeispiel zur Ereignisbehandlung bei einem Anlegen und Speichern eines Dokuments,
- Fig. 7: eine Darstellung des Schnittstellen-Moduls für ein anderes Ausführungsbeispiel zum Anlegen, Ändern und Anzeigen des Materials einer Stücklistenposition,
- Fig. 8: eine Abbildung einer Struktur im CAD-System,
- Fig. 9: eine Abbildung einer Struktur im CAD-Abstraktionslayer,
- Fig. 10: eine Beispieldarstellung zur Verknüpfung von grafischen Elementen,
- Fig. 11: eine Abbildung einer weiteren Struktur im CAD-Abstraktionslayer mit verwalteten Zusatzdaten.

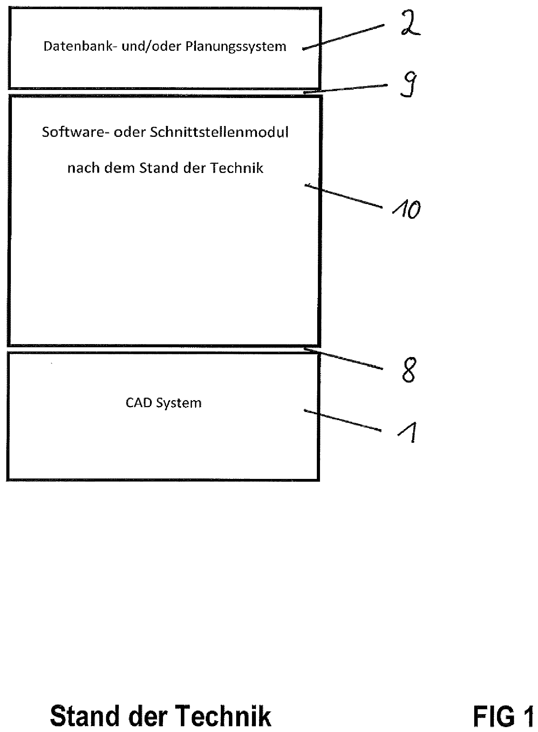

Die Figur 1 zeigt ein Software- oder Schnittstellenmodul 10 nach dem Stand der Technik, welches über eine erste Schnittstelle 8 mit einem CAD-System 1 und über eine zweite Schnittstelle 9 mit einem Datenbank- und Planungssystem 2 verbunden ist. Das Modul 10 ist dabei speziell auf das angeschlossene CAD-System 1 sowie das Datenbank- und Planungssystem 2 ausgerichtet.

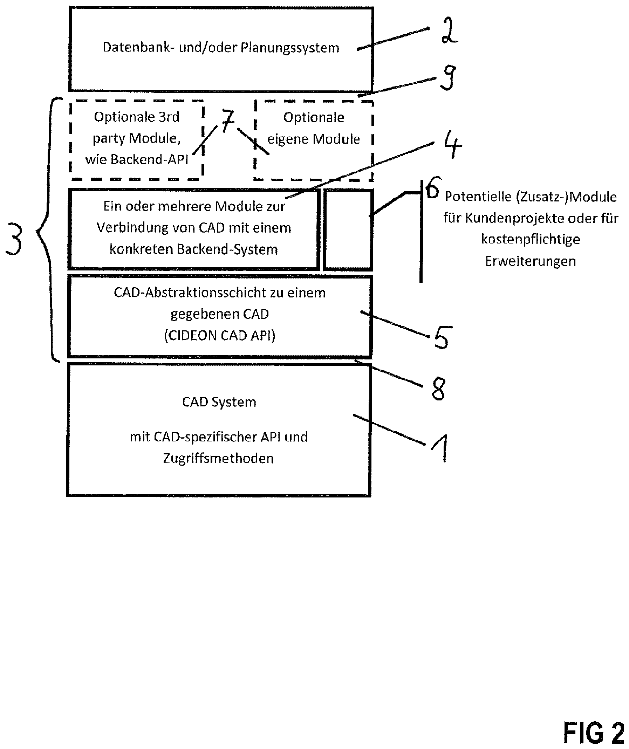

Die Figur 2 zeigt eine Prinzipdarstellung des erfindungsgemäßen Schnittstellen-Moduls 3. Dieses umfasst mindestens einen CAD-Abstraktionslayer 5 und einen Nutzlayer 4. Optional kann dieses auch mindestens ein kundenspezifisches Zusatzmodul 6 und/oder eine Kommunikations-Bibliotheken 7 umfassen.

### In der Figur 2 unterhalb des erfindungsgemäßen

Schnittstellen-Moduls 3 angeordnet ist das CAD-System 1, welches mit dem darüber angeordneten Datenbank- und/oder Planungssystem 2 gekoppelt wird.

Das Schnittstellen-Moduls 3 ist mit dem CAD-System 1 über die erste Schnittstelle 8 und mit dem Datenbank- und/oder Planungssystem 2 über die zweite Schnittstelle 9 verbunden.

Dabei können Kommunikations-Bibliotheken 7 optional eigene Module oder auch sogenannte 3rd party Module wie eine Programmierschnittstelle (Backend-API) umfassen.

Der Nutzlayer 4 kann ein oder mehrere Module umfassen und realisiert die Verbindung zwischen dem CAD-System 1 und dem Backend-System 2.

Der CAD-Abstraktionslayer 5 stellt eine direkte Verbindung zu dem entsprechenden CAD-System 1 her.

Mittels dieser prinzipiellen Unterteilung des Schnittstellen-Moduls 3 in die Teilbestandteile des CAD-Abstraktionslayers 5 und des Nutzlayers 4 ist es möglich, den Aufwand bei der Anpassung des Funktionsumfangs sowie bei der Anpassung an ein neues CAD-System und/oder ein neues Datenbank- und/oder Planungssystem zu verringern, da meist nur in einem der Layer 4 oder 5 eine Änderung erfolgen muss.

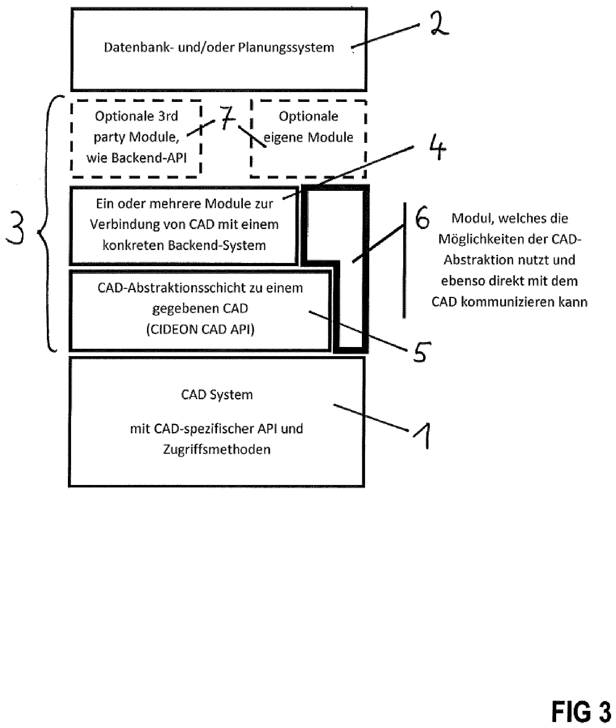

Die Figur 3 zeigt eine Variation des Schnittstellen-Moduls 3, bei welcher das kundenspezifische Zusatzmodul 6 in seiner Funktion gegenüber der Variante in Figur 2 verändert wurde. Das Zusatzmodul 6 hat hier sowohl die Möglichkeit der Nutzung des CAD-Abstraktionslayers 5 als auch die Möglichkeit direkt mit dem CAD-System 1 zu kommunizieren.

Diese Variation ist beispielsweise für extrem CAD-nahe Funktionalitäten oder bei einer fehlenden Abdeckung einer speziellen CAD-Funktionalität im CAD-Abstraktionslayer 5 vorgesehen.

Diese zusätzliche Möglichkeit bietet den Vorteil, dass im Rahmen von Kundenprojekten Funktionalitäten eingebaut werden können, die derzeit nicht durch den CAD-Abstraktionslayer ermöglicht werden.

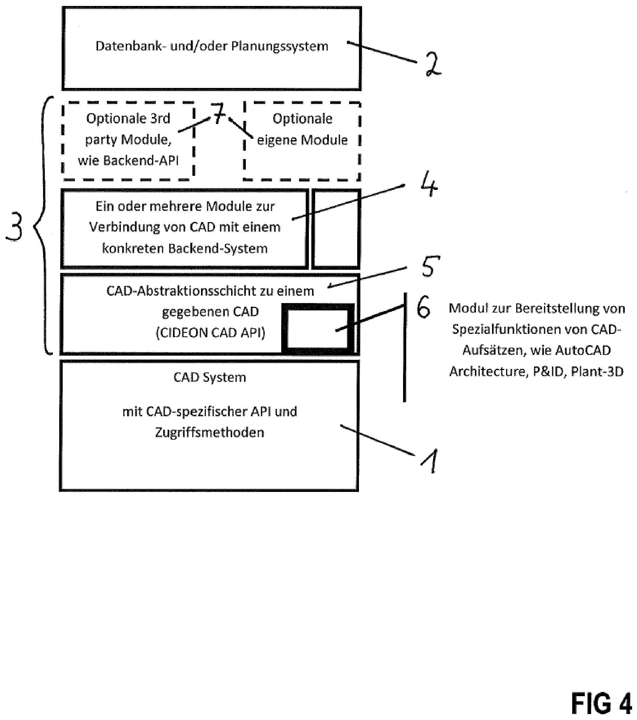

Eine weitere Variation des Schnittstellen-Moduls 3 zeigt die Figur 4. In diesem Fall ist das kundenspezifische Zusatzmodul 6 ein Bestandteil des CAD-Abstraktionslayers 5. Mittels dieser Variante wird die Bereitstellung von Spezialfunktionen von CAD-Aufsätzen wie AutoCAD Architecture, P&ID oder Plant-3D unterstützt.

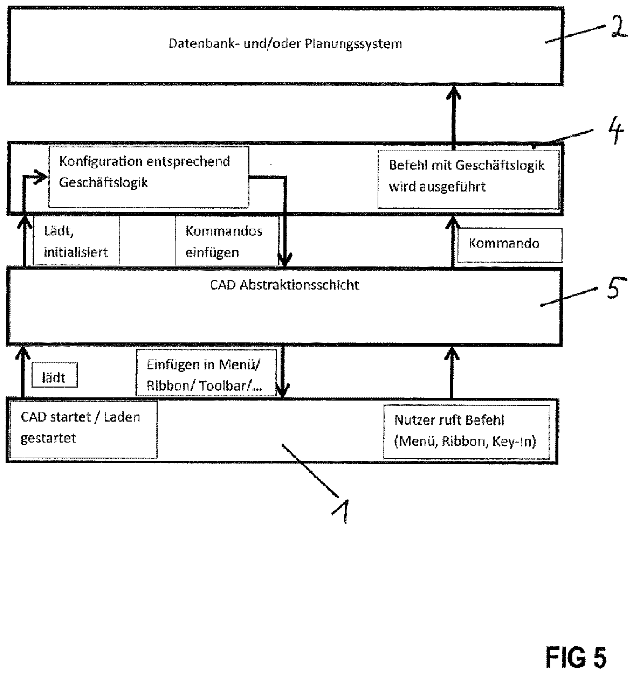

Ein erstes Beispiel für das Zusammenwirken der verschiedenen Schichten der Architektur ist in der Figur 5 dargestellt und wird nachfolgend erläutert.

Zur Vorbereitung der Funktionsweise des Schnittstellen-Moduls 3 erfolgt ein Laden der Module:
Beim Starten des CAD-Systems 1 oder später auf Anforderung durch den Nutzer oder ein Programm lädt das CAD-System 1 mittels seiner Lademethoden ein CAD Modul. Zum Beispiel lädt Inventor eine registrierte COM-DLL, AutoCAD eine arx-Datei mittels AutoLisp oder MicroStation eine ma-Datei.

Das CAD Modul, welches Programmteile zur Erweiterung der Fähigkeiten des CAD-Systems beinhaltet, lädt nun seinerseits angeschlossene Module. Es muss diese Dateien nicht kennen, sondern diese können dynamisch (über Registrierung im COM, über eine ini-Datei, über eine Nutzerauswahl) bestimmt werden. Dazu haben diese Module ein definiertes Interface.

Nachfolgend werden die angeschlossenen Module in der Figur 5 initialisiert.

Die Module legen abstrahierte Kommandos an, die dann vom CAD-Abstraktionslayer 5 im CAD-System 1 bekannt gemacht werden, beispielsweise durch einen Eintrag in das CAD-Menü, durch Einfügen in eine Toolbar oder durch Bereitstellung als aus Scripten aufrufbarem Kommando.

Nachdem die Vorbereitung durch das Laden der Module abgeschlossen ist, ist das Schnittstellen-Modul 3 betriebsbereit.

Die Nutzung des Schnittstellen-Modus 3 kann beispielsweise wie nachfolgend beschrieben erfolgen:
Zu einem späteren Zeitpunkt wird ein Kommando im CAD-System 1 benutzt. Dies kann erfolgen durch Auswahl im Menü, Klick im Toolbar, Eintippen in der Kommandozeile, Key-In, Aufruf aus einer Scriptsprache wie VBA, VSTA oder AutoLisp.

Der CAD-Abstraktionslayer 5 wandelt die Anfrage in ein Kommando um, wie es vom angeschlossenen Modul angemeldet wurde und sendet es an die angeschlossenen Module. Dieser Vorgang ist im rechten Teil der Figur 5 dargestellt.

Die angeschlossenen Module führen nachfolgend den Befehl aus.

Ein weiteres Beispiel zeigt eine Ereignisbehandlung am Beispiel "Dokument Anlegen beim Speichern".

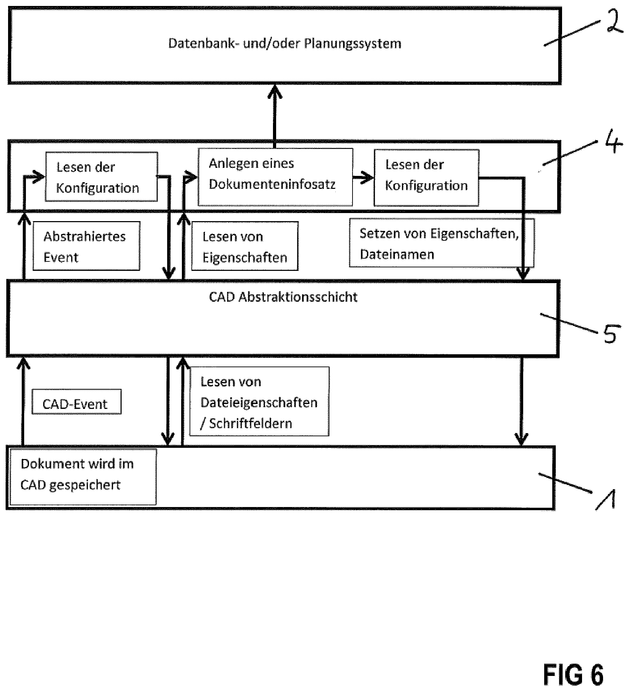

Ein CAD-System 1 sendet in bestimmten Situationen Events aus, wie es im linken Teil der Figur 6 dargestellt ist. Diese Events werden vom CAD-Abstraktionslayer in CADneutrale Events umgesetzt. Die angeschlossenen Module können diese verarbeiten:
- Nutzer löst ein Speichern im CAD-System 1 aus. Alternativ kann das Speichern auch durch ein Programm ausgelöst werden.
- Das CAD-System sendet ein CAD-Event an das im CAD geladene Modul.
- Dieses Modul übersetzt das Event in ein eigenes Event und sendet dieses an die angeschlossenen Module weiter.
- Im Nutzlayer 4 wird jetzt darauf reagiert und es kann konfigurationsgesteuert ein Dokumenteninfosatz angelegt werden, wie in der Figur 6 in der Mitte des Nutzlayers 4 dargestellt.
- Wenn durch die programmierte Logik oder per Konfiguration Informationen zu der betroffenen CAD-Datei benötig werden, dann werden Eigenschaften des abstrahierten Dokuments gelesen.
- Diese Anfrage wird umgesetzt in eine Anfrage zum CAD-Dokument an das CAD-System 1.
- Die Antwort des CAD-Systems 1 wird übersetzt in neutrale Eigenschaften.
- Der DIS (Dokumenteninfosatz) wird angelegt.
- Um die neuen Informationen zum Dokumenteninfosatz in der CAD-Datei zu speichern oder bei Bedarf einen neuen Dateinamen zu vergeben, werden (ggf. nach dem Lesen entsprechender Konfiguration) die Werte an das abstrahierte Dokument zugewiesen.
- Die CAD-Abstraktionslayer 5 setzt diesen Vorgang um in das Setzen der Werte im CAD-System 1.

Das dritte Beispiel zeigt das Anlegen/Ändern/Anzeigen des Materials einer Stücklistenposition.

Das dritte Beispiel zeigt das Anlegen/Ändern/Anzeigen/Verwenden des Materials oder Artikels einer Stücklistenposition.

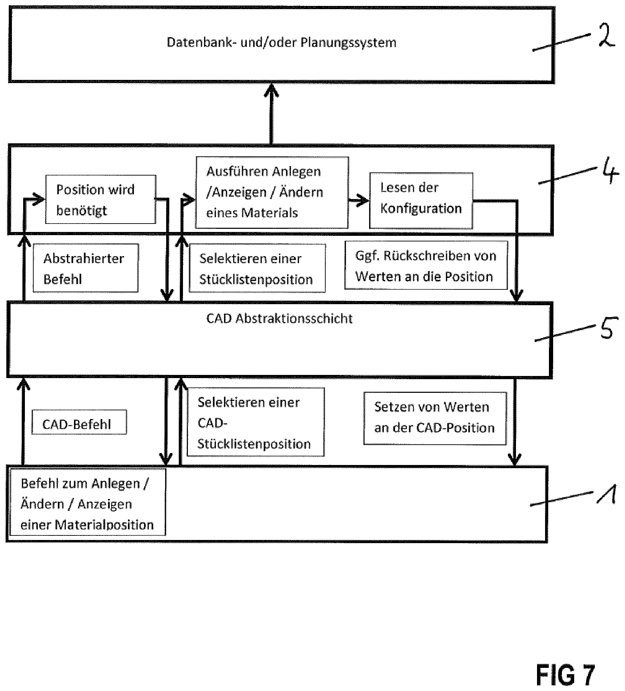

Bei diesem in der Figur 7 dargestellten Ablauf werden mit einer Stücklistenposition im CAD Funktionen ausgeführt, welche auf Material- und/oder Artikelinformationen aus dem Backend-System zurückgreifen.

Hierzu startet der Nutzer einen Befehl im CAD-System.

Die Nutzschicht 4 fordert jetzt die Auswahl einer Stücklistenposition.

Daraufhin setzt der CAD-Abstraktionslayer 5 die Anfrage in eine CAD-spezifische Anfrage um. Bei CAD-Systemen mit einer eigenen Stücklistenverwaltung wie AutoCAD Mechanical oder Inventor werden Stücklistenfunktionen der CAD-API genutzt. Bei CAD-Systemen ohne eigene Stücklistenverwaltung wie AutoCAD ohne Aufsätze oder MicroStation stellt der CAD-Abstraktionslayer 5 selbst eine einfache Stücklistenverwaltung zur Verfügung. Hierzu werden CAD-Objekte mit bestimmten Eigenschaften wie beispielsweise AutoCAD-Blöcke mit bestimmten Blocknamen als Stücklistenpositionen betrachtet und behandelt.

Eine Stücklistenposition im CAD-System hat Eigenschaftsfelder, die durch die Schnittstelle gelesen und geschrieben werden können.
- Schlüsselfeld(er), welche eindeutig das Objekt im Backend-System 2 identifizieren
- Kopierte Felder aus dem Backendsystem 2, welche zur Verarbeitung im CAD-System oder zur Information für den Nutzer gedacht sind, wie beispielsweise ein Kurztext. Welche Felder hierbei gemappt werden, kann durch eine Konfiguration im Nutzlayer 4 oder im Backend-System 2 definiert werden
- Felder mit Informationen aus dem CAD-System, welche zum Transfer in das Backend-System 2 gedacht sind, beispielsweise für die Material-/Artikelanlage, für die Synchronisation oder für die Stücklistenanlage/das Stücklistenupdate im Backend-System 2. Welche Felder hierbei gemappt werden, kann durch eine Konfiguration im Nutzlayer 4 oder im Backend-System 2 definiert werden

Diese Felder werden nun durch den Nutzlayer 5 gelesen und verarbeitet und die gewünschten Funktionen im Backend-System 2 aufgerufen.

Nach dem Beenden der Funktion werden bei Bedarf auch wieder Information aus dem Backend-Objekt in die CAD-Stücklistenposition zurückgeschrieben:
- Schlüsselfelder bei Anlage oder Zuweisen eines Objekts
- Sonstige Felder aus dem Backend-System 2, welche als Information im CAD-System vorliegen sollen

Das vierte Beispiel zeigt das Übertragen einer Struktur.

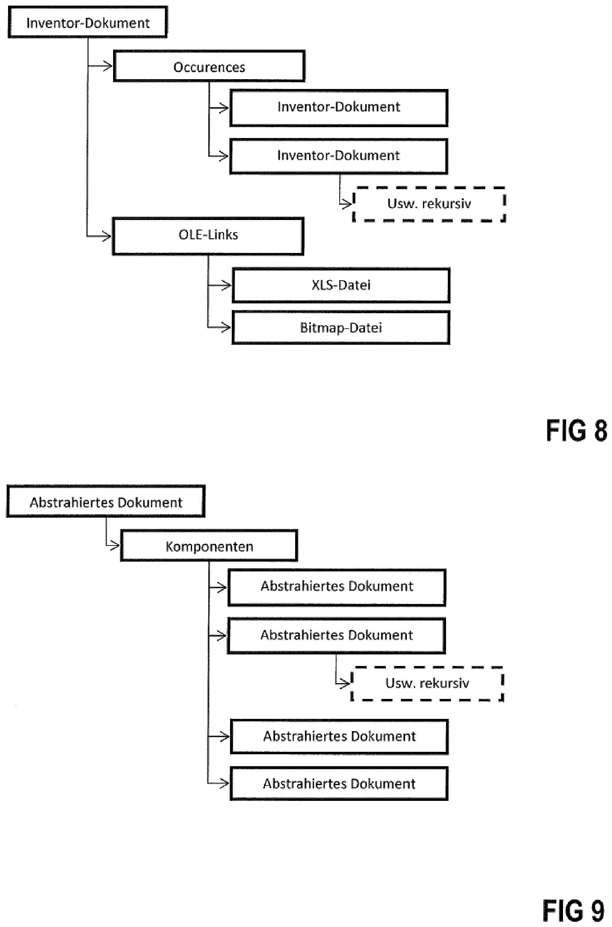

Um die Verwaltung einer 3D-Struktur und allgemein einer CAD-Datei mit abhängigen Dateien zu ermöglichen, muss diese Struktur von Abhängigkeiten ausgelesen und im Backend-System gespeichert werden. In der Figur 8 ist ein Beispiel dargestellt, wie eine Struktur im CAD-System 1 abgebildet werden kann.

Diese Struktur im CAD-System 1 wird in eine in der Figur 9 dargestellte Struktur im CAD-Abstraktionslayer 5 überführt.

Der CAD-Abstraktionslayer 5 stellt eine eigene Struktur zur Verfügung. Auch bei den Beziehungen zwischen abstrahierten Objekten werden die CAD Spezialitäten, z.B. die verschiedenen Typen von Abhängigkeiten vor dem Layer der Geschäftslogik verborgen.

Diese abstrahierte Struktur aus der Figur 9 kann nun benutzt werden, um die Strukturen in das Backend-System 2 zu übertragen, beispielsweise um sie im SAP als Dokumentenstücklisten anzulegen, in SAPs CAD Desktop darzustellen oder sie anderweitig zu verarbeiten. Die Integration kann diese Strukturen ebenfalls nutzen, um in einer eigenen Benutzeroberfläche (Side-Panel, externes Programm) Teile der Struktur oder die Gesamt-Struktur darzustellen, Strukturvergleiche mit den im Backend-System gespeicherten Strukturen anzustellen oder zu verarbeiten.

Eine Verknüpfung von grafischen Elementen ist im fünften Beispiel beschrieben.

In den verschiedenen CAD-Systemen 1 und Aufsätzen zu diesen CAD-Systemen gibt es eine Vielzahl grafischer und nichtgrafischer Elemente, die eine Repräsentation von Objekten darstellen, welche auch im Backend-System 2 verwaltet sein können. Dies können beispielsweise
- Blöcke im AutoCAD
- Zellen in MicroStation
- Flächen in AutoCAD Architectural
- Linien im AutoCAD
- Rohrleitungen in Plant 3D/P&ID
und ähnliche sein.

Diese Elemente enthalten Daten im CAD-System 1, manchmal zusätzlich Daten in einer anwendungsspezifischen Datenbank, manchmal grafische Informationen, wie beispielsweise eine exakte Umrandung. Einige Elemente sind identisch zum dargestellten Element (Rohr, architektonische Fläche), andere sind nur ein Vertreter (Block im AutoCAD mit Metadaten).

Der CAD-Abstraktionslayer 5 liefert nun einen neutralen Zugriff auf ein Objekt und seine Eigenschaften. Auf diese Weise kann auf alle Eigenschaften in gleicher Weise zugegriffen werden, ungeachtet dessen, ob diese aus einem Attribut, einem Datenbankfeld, einer grafischen Berechnung (Fläche) kommen.

Diese neutralen Objekte können jetzt mit Objekten im Backend-System 2 verknüpft werden, wie beispielsweise technische Plätze, Equipments, architektonische Objekte, Materialien im SAP. Die Nutzschicht kann diese Zuordnung hart kodieren oder frei konfigurierbar machen, wodurch die Einbindung weiterer Zielobjekte leicht möglich ist. So kann eine im CAD-System 1 abgebildeter Computer im Backend-System 2 von SAP als ein Equipment abgebildet werden, welchem nun weitere Daten wie beispielsweise Typ, Baujahr, installierte Software und andere Informationen zugeordnet werden können.

Die Verknüpfung kann erfolgen durch das Suchen oder durch die Neuanlage von Objekten im Backend-System 2 mit anschließender Zuweisung von Schlüsselfeldern. Sie kann aber auch durch eine manuelle Änderung eines Schlüsselfeldes erfolgen. Eine Suche kann auch die bereits am abstrahierten CAD-Objekt gesetzten Werte benutzen, um eine halb- oder vollautomatische Zuordnung zu erreichen.

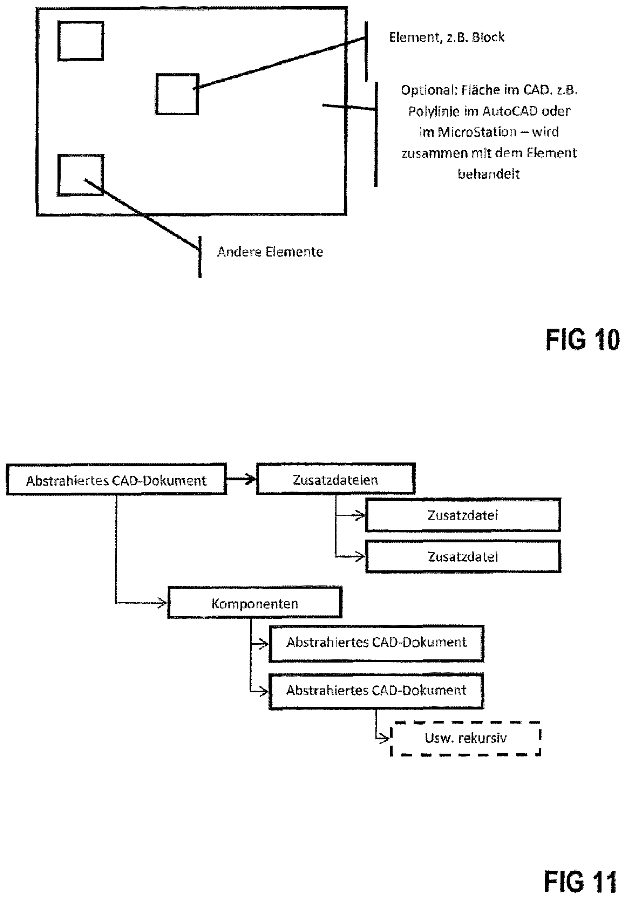

Es ist für den CAD-Abstraktionslayer 5 ebenfalls möglich, eine Fläche oder ein Polygon, die eigentlich ein eigenes Element darstellt, zusammen mit einem Block, der ebenfalls ein eigenes Element darstellt, zu behandeln. Somit sieht es aus Sicht des Nutzlayers 4 so aus, als ob das Element "Block", welches sich hinter dem neutralen Objekt verbirgt, eine Fläche hätte. Ein Beispiel hierfür ist in der Figur 10 dargestellt.

Die Zuordnung eines Elementes zu einer Fläche kann durch eine automatische Erkennung erfolgen. Dabei können Bedingungen wie ein Blocknamen, ein Zeichnungs-Layernamen, Inhalte von Feldern, eine Erkennung, dass ein Element innerhalb einer Fläche liegt, beachtet werden.

Die Zuordnung eines Elementes kann auch durch eine Nutzerzuordnung erfolgen, wodurch ein Element auch außerhalb einer Fläche liegen darf, wenn die Fläche zu klein ist.

Es wird ebenfalls eine Information darüber bereitgestellt, ob andere Elemente sich innerhalb der Fläche befinden, gerade in die Fläche eingefügt, heraus bewegt oder gelöscht werden. Auf diese Weise ist es dem Nutzlayer 4 ohne das Wissen um grafische Informationen möglich, Beziehungen zwischen Objekten im Backend-System 2 synchron oder auf Anforderung zu aktualisieren.

Zum Beispiel kann beim Einfügen eines entsprechend konfigurierten Blockes die Anlage eines Equipments bewirkt werden, beim Löschen eines Blockes der Status auf ungültig gesetzt werden, und beim Verschieben des Blockes aus der Fläche eines anderen Blockes kann ein Ausbau des Equipments aus einem technischen Platz erfolgen.

Das sechste Beispiel beschreibt das Verarbeiten von Projekten.

In einigen CAD-Systemen 1 reicht es nicht, CAD-Dokumente und ihre referenzierten Dateien zu betrachten, hier müssen mehrere CAD-Dokumente als ein Satz von Dokumenten betrachtet werden.

Dies ist beispielsweise der Fall in Plant 3D, wo mehrere CAD-Dokumente einem Plant-3D-Projekt zugeordnet sind. Das Projekt hat seinerseits weitere Dateien, wie Konfigurationsdateien oder Datenbanken.

Im AutoCAD Electrical gibt es Electrical-Projekte, die CAD-Dateien mit anderen zusätzlichen Dateien zusammen verwalten.

Im Standard AutoCAD gibt es sogenannte Plansätze (Sheet Sets), welche dazu benutzt werden können, Dateien zusammen auszugeben oder einen schnelleren Zugriff auf zugehörige Dateien zu ermöglichen.

Damit ist es nicht mehr ausreichend, die Strukturen der CAD-Dokumente zu betrachten.

Die Lösung besteht darin, am abstrahierten CAD-Dokument eine Funktion für die Nutzschicht 2 bereitzustellen, welche die Frage beantwortet, ob das CAD-Dokument einem übergeordneten "Klammerobjekt" zugehörig ist, und falls ja, einen Zugriff auf ein abstrahiertes "Projekt"-Objekt zu ermöglichen, welches dann seinerseits wieder den Zugriff auf alle referenzierten Dokumente erlaubt.

Somit kann die Nutzschicht 2 unabhängig von der konkreten Art der "Klammer" (Projekt, Sheet Set) von einem gegebenen Dokument beispielsweise in der Struktur der Figur 2 oder 5 "nach oben gehen" und statt vom geladenen Dokument vom übergeordneten Projekt aus die komplette Struktur auflösen.

Auf diese Weise ist eine Zusammenbehandlung der durch das Projekt zusammengefassten Dokumente im Backend-System 2 möglich, wie die Ablage der Struktur, ein gemeinsames Einchecken oder auschecken, etc.

Das siebente Beispiel beschreibt die Verarbeitung von Zusatzdateien.

Einige CAD-Dateien haben zusätzliche referenzierte Dateien, welche nur zu dieser CAD-Datei gehören und nicht allein sinnvoll verwendet oder von anderen CAD-Dateien referenziert werden können. Beispiele sind die sogenannten idv-Dateien in älteren Inventor-Versionen, referenzierte Altzeichnungen im MicroStation und Simulationsdateien im Inventor. Da diese im Backend-System 2 möglichst keinen eigenen Dokumenteninfosatz erhalten sollen, sondern am Dokumenteninfosatz der CAD-Datei als zusätzliches Original zugeordnet werden sollen, stellt der CAD-Abstraktionslayer 5 diese Dateien nicht als referenzierte Dateien dar, sondern als Zusatzdatei zur CAD-Datei dar.

Ein Beispiel für eine derartige Struktur ist in der Figur 11 dargestellt.

Zusatzdateien an Projekten wie Projektdatenbanken, Projektkonfigurationsdateien und andere werden auch in dieser Art und Weise verarbeitet.

### Bezugszeichenliste

- 1: CAD-System
- 2: Datenbank- und/oder Planungssysteme
- 3: Schnittstellen-Modul
- 4: Nutzlayer
- 5: CAD-Abstraktionslayer
- 6: Zusatzmodule, kundenspezifisch/CAD spezifisch oder mit bestellbaren Zusatzoption
- 7: Kommunikations-Bibliotheken
- 8: erste Schnittstelle
- 9: zweite Schnittstelle
- 10: Software- oder Schnittstellenmodul nach dem Stand der Technik

## Patentansprüche

1. Verfahren zur Kopplung eines CAD-Systems (1) mit einem Datenbank- und Planungssystem (2) zum Austausch von Daten zwischen beiden Systemen, wobei eine erste CAD-seitige Schnittstelle (8) mit einem ersten Kommunikationsprotokoll arbeitend und eine zweite datenbankseitige Schnittstelle (9) mit einem zweiten Kommunikationsprotokoll arbeitend bereitgestellt werden und wobei zwischen der ersten und der zweiten Schnittstelle (8, 9) eine Umsetzung der zu übertragenden Daten aus dem ersten Kommunikationsprotokoll in das zweite Kommunikationsprotokoll und umgekehrt erfolgt, wobei ein Schnittstellen-Modul (3) bereitgestellt wird, welches einen Nutzlayer (4) und einen CAD-Abstraktionslayer (5) beinhaltet und in welchem die Umsetzung zwischen den Kommunikationsprotokollen in zwei Teilschritten derart erfolgt, dass die Daten aus dem ersten Kommunikationsprotokoll in dem CAD-Abstraktionslayer (5) in ein drittes Kommunikationsprotokoll und nachfolgend aus diesem dritten Kommunikationsprotokoll in das zweite Kommunikationsprotokoll in dem Nutzlayer (4) umgesetzt werden und umgekehrt, und wobei ein vom CAD-System (1) erzeugtes und an den CAD-Abstraktionslayer (5) gesendetes CAD-Event in dem CAD-Abstraktionslayer (5) in ein neutrales CAD-Event umgewandelt wird, welches mittels angeschlossener Module im Nutzlayer (4) verarbeitet werden kann.

2. Verfahren nach einem der Ansprüche 1, **dadurch gekennzeichnet, dass** im CAD-Abstraktionslayer (5) abstrahierte Kommandos hinterlegt werden, dass bei einem Aufruf eines Kommandos im CAD-System (1) eine Übertragung dieses Kommandos an den CAD-Abstraktionslayer (5) erfolgt, welcher das Kommando in ein abstrahiertes Kommando umwandelt und an angeschlossene Module im Nutzlayer (4) übertragt.

3. Verfahren nach Anspruch 2, **dadurch gekennzeichnet, dass** der Nutzlayer (4) die abstrahierten Kommandos dem CAD-Abstraktionslayer (5) mitteilt, welcher diese mittels eines Eintrags in ein CAD-Menü oder Einfügen in eine Toolbar oder mittels eines aus Scripten aufrufbaren Kommandos im CAD abrufbar bereitstellt.

4. Verfahren nach einem der Ansprüche 1 bis 3, **dadurch gekennzeichnet, dass** bei der Umsetzung der Daten aus dem dritten Kommunikationsprotokoll in das zweite Kommunikationsprotokoll oder umgekehrt weitere Zwischenschritte zur Anpassung der Kommunikation durch Kommunikations-Bibliotheken eingefügt werden.

5. Verfahren nach einem der Ansprüche 1 bis 4, **dadurch gekennzeichnet, dass** die Umsetzungen zwischen den Kommunikationsprotokollen unter Beachtung weiterer CAD- oder kundenspezifischer Vorgaben erfolgen.

## Claims

1. A method for coupling a CAD system (1) to a database and planning system (2) for exchanging data between the two systems, a first CAD-sided interface (8) operating with a first communication protocol and a second database-sided interface (9) operating with a second communication protocol being provided, and the data to be transferred from the first communication protocol to the second communication protocol and vice versa being converted between the first and the second interface (8, 9), with an interface module (3) being provided, which contains an utility layer (4) and a CAD abstraction layer (5) and in which the conversion between the communication protocols takes place in two sub-steps in such a way that the data are converted from the first communication protocol in the CAD abstraction layer (5) into a third communication protocol and subsequently from said third communication protocol into the second communication protocol in the utility layer (4) and vice versa, and wherein a CAD event generated by the CAD system (1) and sent to the CAD abstraction layer (5) is converted in the CAD abstraction layer (5) into a neutral CAD event which can be processed using connected modules in the utility layer (4).

2. The method according to claim 1, **characterized in that** abstracted commands are deposited in the CAD abstraction layer (5), so that when a command is called in the CAD system (1), this command is transmitted to the CAD abstraction layer (5), which converts the command into an abstracted command and transmits it to connected modules in the utility layer (4).

3. The method according to claim 2, **characterized in that** the utility layer (4) communicates the abstracted commands to the CAD abstraction layer (5), which makes them available in CAD by means of an entry in a CAD menu or insertion in a toolbar or by means of a command which can be called from scripts.

4. The method according to one of claims 1 to 3, **characterized in that** further intermediate steps for adapting the communication are inserted by communication libraries when converting the data from the third communication protocol into the second communication protocol or vice versa.

5. The method according to one of claims 1 to 4, **characterized in that** the conversions between the communication protocols take place taking into account further CAD or customer-specific specifications.

## Revendications

1. Procédé de couplage d'un système de CAO (1) avec un système de base de données et de planification (2) pour l'échange de données entre les deux systèmes, une première interface côté CAO (8), fonctionnant avec un premier protocole de communication, et une deuxième interface côté base de données (9), fonctionnant avec un deuxième protocole de communication, étant mises à disposition et, entre la première et la deuxième interface (8, 9), une conversion des données à transmettre du premier protocole de communication au deuxième protocole de communication et inversement ayant lieu, un module d'interface (3) étant mis à disposition, qui contient une couche utilitaire (4) et une couche d'abstraction CAO (5) et dans lequel la conversion entre les protocoles de communication est réalisée en deux étapes de façon à ce que les données du premier protocole de communication soient converties, dans la couche d'abstraction CAO (5), en un troisième protocole de communication puis de ce troisième protocole de communication dans le deuxième protocole de communication dans la couche utilitaire (4) et inversement et un événement CAO, généré par le système de CAO (1) et envoyé à la couche d'abstraction CAO (5), est converti, dans la couche d'abstraction CAO (5), en un événement CAO neutre qui peut être traité au moyen de modules connectés dans la couche utilitaire (4).

2. Procédé selon l'une des revendications 1, **caractérisé en ce que**, dans la couche d'abstraction CAO (5) sont enregistrées des commandes abstraites de façon à ce que, lors de l'appel d'une commande dans le système de CAO (1), cette commande soit transmise à la couche d'abstraction CAO (5) qui convertit la commande en une commande abstraite et la transmet à des modules connectés dans la couche utilitaire (4).

3. Procédé selon la revendication 2, **caractérisé en ce que** la couche utilitaire (4) communique les commande abstraites à la couche d'abstraction CAO (5) qui met celles-ci à disposition de façon à ce qu'elles puissent être appelées au moyen d'une entrée dans un menu CAO ou d'une insertion dans une barre d'outils ou au moyen d'une commande pouvant être appelée à partir de scripts dans la CAO.

4. Procédé selon l'une des revendications 1 à 3, **caractérisé en ce que**, lors de la conversion des données du troisième protocole de communication dans le deuxième protocole de communication ou inversement, des étapes intermédiaires supplémentaires sont ajoutées pour l'adaptation de la communication à l'aide de bibliothèques de communication.

5. Procédé selon l'une des revendications 1 à 4, **caractérisé en ce que** la conversion entre les protocoles de communication a lieu en tenant compte de directives supplémentaires spécifiques à la CAO ou au client.
